Europäisches Patentamt

European Patent Office

Office européen des brevets

(11) Publication number: **0 037 252**
**B1**

(12) **EUROPEAN PATENT SPECIFICATION**

(45) Date of publication of patent specification: **11.06.86**

(21) Application number: **81301296.0**

(22) Date of filing: **26.03.81**

(51) Int. Cl.⁴: **G 11 C 7/00, G 11 C 11/24, G 11 C 8/00**

(54) Dynamic semiconductor memory.

(30) Priority: **28.03.80 JP 39891/80**

(43) Date of publication of application:
**07.10.81 Bulletin 81/40**

(45) Publication of the grant of the patent:
**11.06.86 Bulletin 86/24**

(84) Designated Contracting States:
**DE FR GB NL**

(56) References cited:
**US-A-4 044 335**
**US-A-4 106 109**

**IEEE INTERNATIONAL SOLID STATE CIRCUITS CONFERENCE, 19th February 1976, pages 136-137, New York (USA); J.M. SCHLAGETER et al.: "A 4K static 5-V RAM"**

(73) Proprietor: **FUJITSU LIMITED**
**1015, Kamikodanaka Nakahara-ku Kawasaki-shi Kanagawa 211 (JP)**

(72) Inventor: **Takemae, Yoshihiro**
**20-5-9-301, Utsukushigaoka 1-chome Midori-ku Yokohama-shi Kanagawa 227 (JP)**

(74) Representative: **Sunderland, James Harry et al HASELTINE LAKE & CO Hazlitt House 28 Southampton Buildings Chancery Lane London WC2A 1AT (GB)**

Courier Press, Leamington Spa, England.

## Description

The present invention relates to a dynamic semiconductor memory.

A dynamic memory essentially requires a reset period. In a conventional dynamic memory in which all functional portions thereof are reset at one time, memory cycle time is the sum of a period (access time) lasting from the start of access to a portion to which access is first made, at a first access moment, to the completion of access to a portion to which access is last made, and a reset time. On the other hand, a static memory does not require resetting. Therefore, the cycle time of a static memory is nearly equal to its access time. Thus, a dynamic memory having a long cycle time is capable of writing and reading a smaller quantity of data in a unit period of time than a static memory.

IEEE International Solid State Circuits Conference, 19th February 1976, pages 136 to 137, New York (US), J. M. Schlageter et al, "A 4K Static 5-V RAM", discloses a static semiconductor memory device having pipelined peripheral circuitry. The device has functional blocks such as row address buffer and latch, row address decoder, timing control, column address buffer and latch, column address decoder, chip select buffer, I/O control logic, etc. A chip enable signal initiates and controls all memory operations. When this signal is low all cells of the memory are deselected and data and bit lines are equalized to an intermediate voltage. When this signal goes high address and chip select inputs are latched into on-chip buffers and memory access is begun.

A memory status signal is provided the rising edge of which indicates that output data is valid and that the chip enable signal may be brought low so that a memory preset period may begin. The falling edge of the memory status signal indicates that preset is complete and a new cycle may begin. The memory may be self-time using the memory status signal inverted to provide the chip enable signal.

US—A—4 106 109 discloses a dynamic RAM wherein new data is addressed in the memory matrix while the data previously read into the output register is selectively applied to the data output line so that when the output register is ready to receive a new set of data, the new data is already addressed in the matrix and ready for presentation to the output register thus enabling the data output rate to be higher than the rate at which data can be accessed.

According to the present invention there is provided a dynamic semiconductor memory comprising a plurality of functional blocks such as a row-enable buffer, a row address buffer which receives an output signal of said row-enable buffer, a word decoder which is connected to said row address buffer, a group of sense amplifiers, a column enable buffer a column address buffer which receives an output signal of said column enable buffer, a column decoder which receives a column address signal from said column address buffer and which selects one of said sense amplifiers, a data buffer which receives an output of the selected sense amplifier, and an output buffer which is connected to said data buffer, characterised in that individual functional blocks are successively reset, each immediately after a processing operation thereof so as to be ready to execute a next processing operation.

The present invention provides a dynamic semiconductor memory from which drawbacks of a conventional dynamic memory are substantially removed.

The present invention provides a dynamic semiconductor memory which can offer a reduced cycle time.

The present invention provides a dynamic semiconductor memory having a cycle time which is equal to, or shorter than, an access time.

Reference is made, by way of example, to the accompanying drawings, in which:—

Figures 1 and 2 are respectively a block diagram and a time chart illustrating the construction and operation of a major part of a conventional dynamic memory;

Figures 3 and 4 are respectively a block diagram and a time chart illustrating an embodiment of the present invention and operation thereof;

Figures 5 and 6 are respectively a diagram illustrating in detail a row-enable buffer circuit of Figure 3 and a waveform diagram for illustrating operation of the row enable buffer circuit;

Figure 7 is a diagram illustrating in detail a word decoder, sense amplifiers, a column decoder and a writer system circuit of Figure 3;

Figures 8A, 8B and 8C are diagrams illustrating in detail a column decoder, a data buffer and an output buffer of Figure 3; and

Figures 9A, 9B and 9C are waveform diagrams for illustrating operations of the circuits shown in Figures 8A, 8B and 8C.

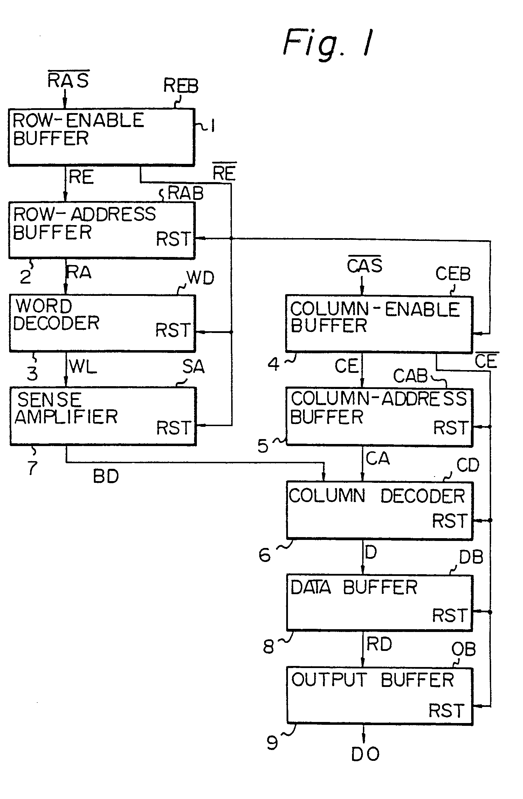

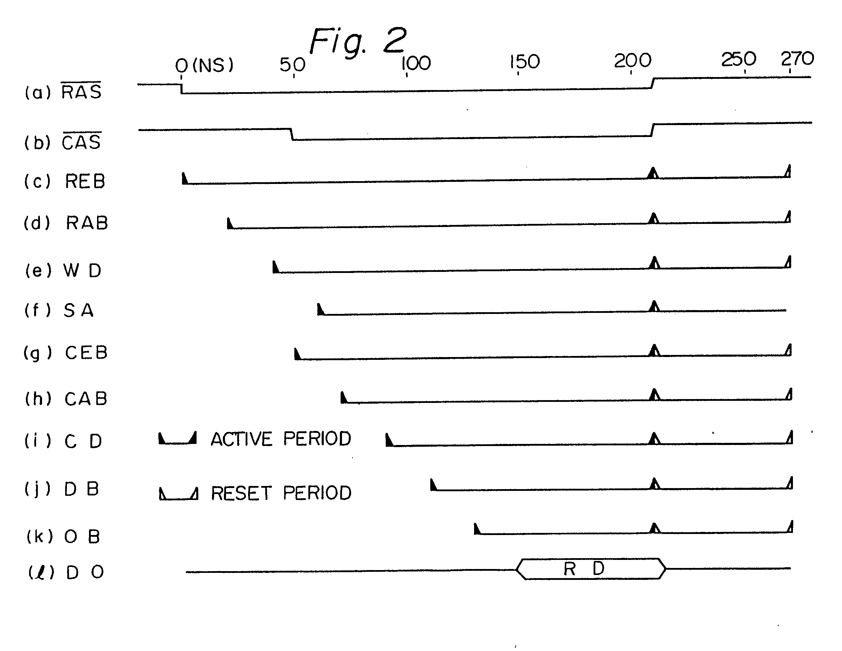

Figures 1 and 2 illustrate the construction and operation of a major part (peripheral circuitry) of a conventional dynamic memory as most generally employed. As an inverted row address strobe signal $\overline{RAS}$ assumes a L (low) level, row system circuitry commences to operate, and a row-enable buffer (REB)1, a row-address buffer (RAB)2 and a word decoder (WD)3 produce outputs RE, RA and WL, respectively. Then, as an inverted column address strobe signal $\overline{CAS}$ assumes a L level, column system circuitry commences to operate, whereby a column-enable buffer (CEB)4, a column-address buffer (CAB)5 and a column decoder (CD)6 produce outputs CE, CA and D, successively. Here, one of the outputs BD of sense amplifiers (SA)7 produced by the operation of the row system is selected by the column decoder 6, and is converted into read data RD and data out DO via data buffer (DB)8 and output buffer (OB)9. At the time when the operation of the output buffer (OB)9 is finished, the inverted signals $\overline{RAS}$ and $\overline{CAS}$ assume a H (high) level. Therefore, the row-enable buffer (REB)1 and column-enable buffer (CEB)4 produce reset signals $\overline{RE}$ and $\overline{CE}$, so that the row address buffer (RAB), the word decoder (WD), ... the column address buffer (CAB) and the column decoder (CD) ... are reset at one time.

In Figure 2 numerals 0, 50, 100 ... at the top of the time chart represent lapse of time in nanosecond units. The cycle time can be seen to be 270 nanoseconds. On the other hand, the time $t_{RAC}$ from the start of access to a moment at which read data RD is produced is 150 nanoseconds. Therefore, the cycle time is considerably longer than the time $t_{RAC}$.

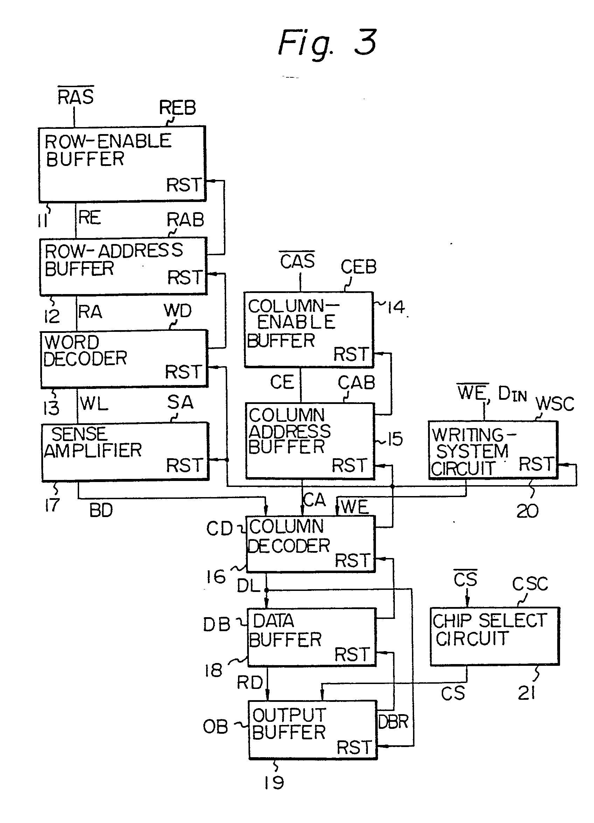

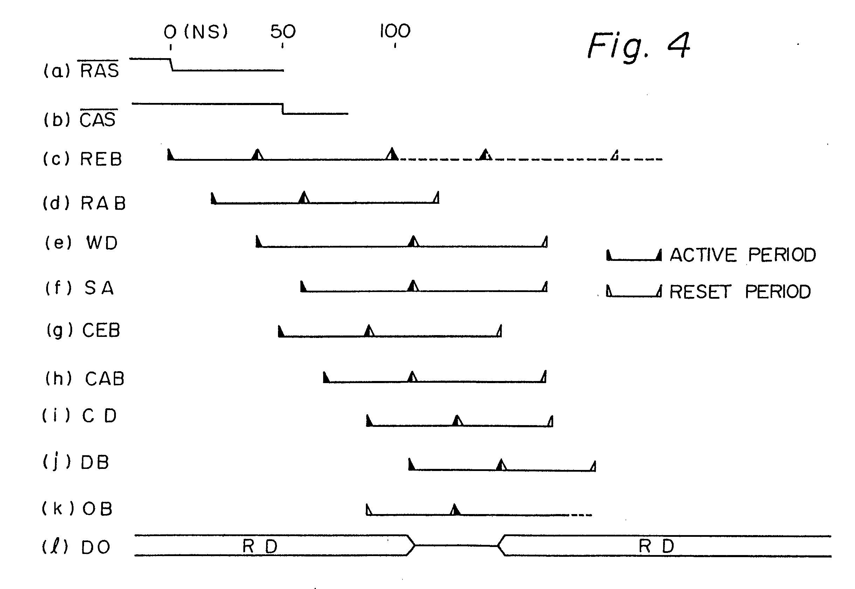

Figures 3 and 4 illustrate the construction and operation of a major part of a memory embodying the present invention. As illustrated in the diagrams, individual portions in an embodiment of the present invention are reset immediately after an operation thereof is finished, and are ready to start a next operation. Namely, a row system and column system commence operation when inverted signals $\overline{RAS}$ and $\overline{CAS}$ assume the L level. Here, however, row-enable buffer (REB)11 is immediately reset by a signal which is caused by operation of row-address buffer (RAB)12 (the next stage functional block). The same also holds true for the row-address buffer (RAB)12 and column-enable buffer (CEB)14 (which are reset by operation of respective next stage functional blocks word decoder (WD)13 and column address buffer (CAB)15), without the need to waiting for the return of signals $\overline{RAS}$ and $\overline{CAS}$. Therefore, when resetting is finished, the individual portions enter again into an active period to perform a next operation. Consequently, the cycle time becomes equal to the sum of active period and reset time, and is greatly reduced. Although it is difficult to perform a read-modify-write operation, cycle time is so shortened that there practically arises no problem. Further, a dynamic memory which performs an address multiplex operation must latch a row address as well as a column address, and hence necessitates two clock signals $\overline{RAS}$ and $\overline{CAS}$. If a column address is latched by utilizing the rise in block $\overline{RAS}$, however, the clock $\overline{CAS}$ need not be employed.

When a writing operation is taken into consideration, for the writing operation word decoder (WD)13 must be reset after completion of operation of column decoder (CD)16 which is a block of the next but one stage (the second stage—the first one is skipped). Further, output buffer (OB)19 which produces read data at an output terminal receives a reset signal from column decoder 16 when the column decoder commences operation, and starts resetting operation, and completes resetting operation while data buffer (DB)18 is being operated. Thus, with the output buffer 19 being reset, it is possible to retain the read data of the previous cycle up to a moment just before new read data is produced. In this case, read data is produced at the output terminal at all times, and it is not allowed to utilize the output terminal in common for another memory or to connect the output terminal in parallel with another memory. The output terminal can be connected in parallel with another memory if a chip select circuit (CSC)21 is provided and the output buffer 19 is controlled by output signal CS of (CSC)21. In Figure 3, reference numeral 20 (WSC) denotes a writing system circuit, a signal $\overline{WE}$ denotes an inverted write-enable signal, and a signal $D_{IN}$ denotes writing data. The numerals 0, 50, 100 ... shown at the top of Figure 4 denote lapse of time in nanosecond units. The time $t_{RAC}$ from first access to a moment at which the read data is produced is 150 nanoseconds, the same as for the conventional memory shown in Figure 1. On the other hand, the row enable buffer (REB)11 commences reset after only 40 nanoseconds and reset is complete at 100 nanoseconds, so that at time 100 NS a next operation cycle of (REB)11 can be carried out. Therefore, one cycle of (REB)11 can be completed in 100 nanoseconds. Further, functional blocks other than the row enable buffer (REB)11 can similarly complete one cycle in 100 nanoseconds. However, word decoder WD has a cycle time of about 125 nanoseconds, as can be seen from Figure 4. Therefore, the memory can be operated with a cycle time of about 125 nanoseconds. This cycle time of 125 nanoseconds is more rapid than that of a conventional memory which has a cycle time of 270 nanoseconds, so that the function of a memory embodying the present invention is greatly improved.

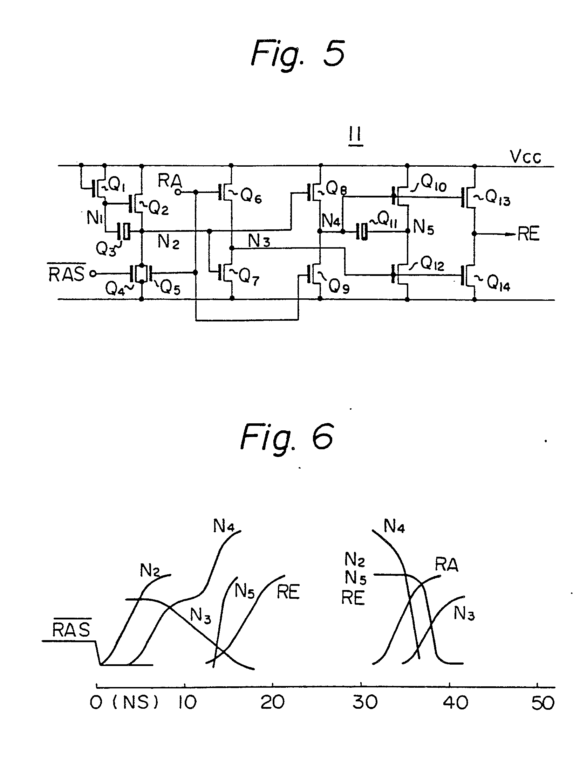

Figure 5 and 6 respectively illustrate a practical circuit and timings relating thereto with regard to row-enable buffer (REB)11. Symbols $Q_1$ to $Q_{14}$ denote MOS transistors or MOS capacitors, and $N_1$ to $N_5$ denote nodes or potentials at the nodes. When the inverted signal $\overline{RAS}$ assumes a low level, the node $N_2$ assumes a high level the transistors $Q_7$, $Q_8$ are rendered conductive, the node $N_4$ assumes a high level, the node $N_3$ assumes a low level the transistors $Q_{10}$, $Q_{13}$ are rendered conductive, the transistors $Q_{12}$, $Q_{14}$ are rendered non-conductive, and the node $N_5$ and output RE assume a high level. When the output RE assumes a high level, the row-address buffer (RAB)12 operates to produce output signal RA of a high level. The signal RA is fed back to the row-enable buffer (REB)11 in Figure 5, whereby the transistors $Q_5$, $Q_6$ and $Q_9$ are rendered conductive, the node $N_2$ assumes a low level, the transistors $Q_7$, $Q_8$ are rendered non-conductive, the node $N_3$ assumes a high level, the node $N_4$ assumes a low level, the transistors $Q_{10}$, $Q_{13}$ are rendered non-conductive, the transistors $Q_{12}$, $Q_{14}$ are rendered conductive, and the node $N_5$ and the output RE assume a low level. Here, since the signal RA is reset by the completion of the operation of word decoder (WD)13, the inverted signal $\overline{RAS}$ must be assumed to be high level before the signal RA is reset. If the inverted signal $\overline{RAS}$ is maintained at low level, the row-enable buffer (REB)11 commences the next operation when the signal RA is reset.

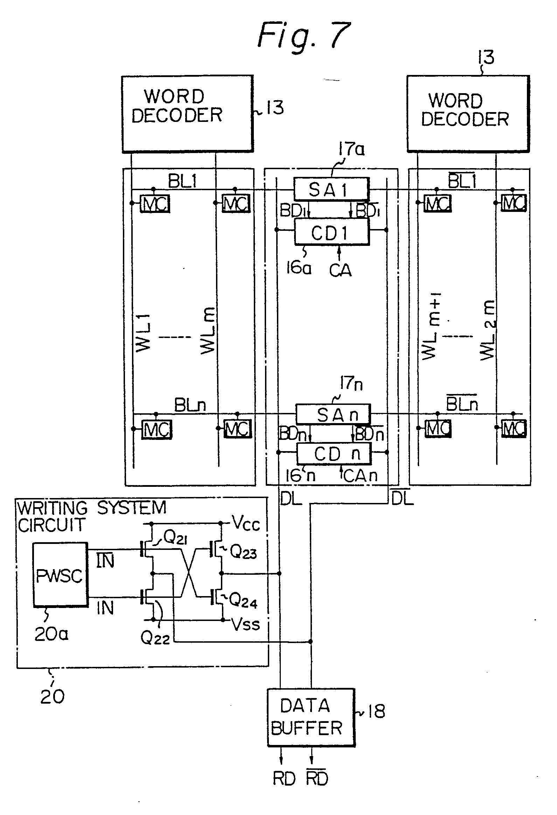

Figure 7 illustrates a practical circuit including word decoder 13, column decoder 16, sense amplifier 17, data buffer 18 and writing system circuit 20 in Figure 3. As seen from Figure 3, almost all functional blocks receive a reset signal from the next following functional block. However, the word decoder (WD)13 should receive a reset signal after the time in which the function of the column decoder is completed. Next we will explain the reason why the word decoder (WD)13 should receive the reset signal from the column decoder which is a block of the next but one stage following the word decoder. As illustrated in Figure 7, the sense amplifier 17 in Figure 3 is formed by a group of sense amplifiers 17a, . . ., 17n, the column decoder 16 in Figure 3 is formed by a group of column decoders 16a, . . ., 16n and the write system circuit 20 includes a writing circuit 20a and a buffer amplifier which includes transistors $Q_{21}$, $Q_{22}$, $Q_{23}$ and $Q_{24}$. In the circuit shown in Figure 7, outputs WL1, . . . WL2m of the word decoder are coupled via memory cells MC and bit lines BL1, . . ., BLn and $\overline{BL1}$ . . . $\overline{BLn}$ to the sense amplifiers 17a, . . ., 17n. The column decoders 16a, . . ., 16n receive the outputs (BD1, $\overline{BD1}$ . . ., BDn $\overline{BDn}$) from the sense amplifiers 17a, . . ., 17n and the output signal CA from the column address buffer 15, and the output signal of the column decoders 16a, . . ., 16n are coupled via lines DL and $\overline{DL}$ to the data buffer 18. In reading operation, the word decoder (WD)13 selects one of the word lines WL1~WL2m and the data of the memory cells which are connected to the selected word line are transmitted to the bit lines and amplified by the sense amplifiers SA1~SAn, and only the data which is selected by the column decoder CD1~CDn is transmitted to the lines DL and $\overline{DL}$. When the reading operation is carried out in such a manner, the word decoder (WD)13 can be reset after the data of the memory cells are transmitted to the bit lines and amplified by the sense amplifiers. Therefore, it is not necessary to await operation of the column decoder (CD)16. Contrariwise, in writing operation, the data which is written in the lines DL, $\overline{DL}$ by the writing system circuit 20 is written via the column decoder, the sense amplifier and the bit lines in the memory cell which is selected by the word lines. Therefore, the word lines cannot be reset till the time when the column decoder is operated and the data is written in the memory cells via the lines DL, $\overline{DL}$ and the bit lines. This is the reason why the word decoder (WD)13 receives the reset signal from the column decoder (CD)16.

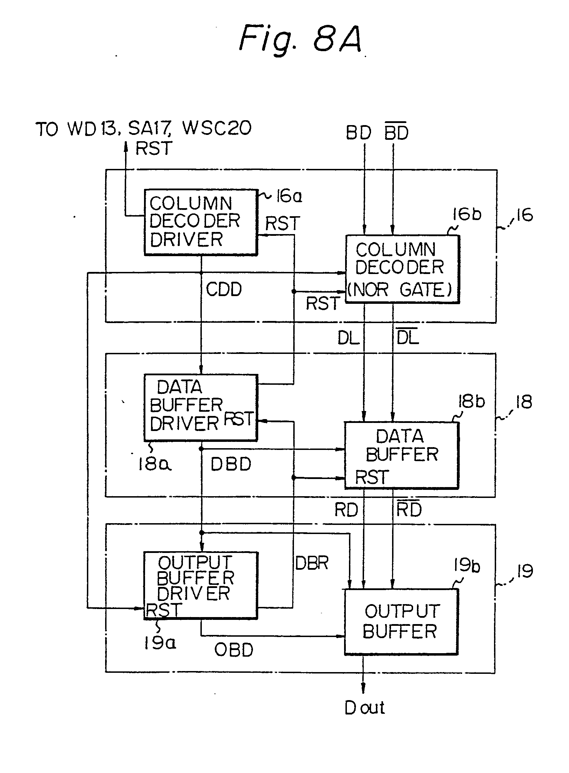

As shown in Figure 3, different from the other blocks, the output buffer (OB)19 receives a reset signal from the column decoder 16 which is two stages from the output buffer 19. This is because read data is maintained at the output terminal $D_{out}$ till the next data is output at said output terminal $D_{out}$. If it is not necessary to output the data before the next data is output, the chip select circuit (CSC)21 may control the output buffer (OB)19 so as to disable the output $D_{out}$. For the purpose of explaining the method of resetting the output buffer (OB)19, a more detailed functional block diagram of the column decoder, the data buffer and the output buffer are shown in Figures 8A to 8C.

The column decoder 16 shown in Figure 3, includes a column decoder driver 16a and a column decoder 16b as shown in Figure 8A, the data buffer 18 shown in Figure 3 includes a data buffer driver 18a and a data buffer 18b as shown in Figure 8A, and the output buffer 19 shown in Figure 3 includes an output buffer driver 19a and an output buffer 19b. A reset signal is supplied from the column decoder driver 16a to the word decoder 13, the sense amplifier 17 and the writing system circuit 20, the data buffer driver 18a generates a reset signal for the column decoder driver 16a and the column decoder 16b. Reset of the output buffer 19 is commenced by an output signal CDD of the column decoder driver 16a. On the other hand, the data buffer commences operation in dependence upon signal CDD, so that the output buffer driver 19a is reset during the operation of the data buffer 18b. When the output buffer driver 19a is reset, the output OBD of said output buffer driver 19a is also reset so that the output buffer 19b is reset at the same time. The output buffer driver 19a and the output buffer 19b are completely reset till the time when the data buffer driver 18a outputs the output signal DBD. Therefore, the output buffer 19b can receive the signal DBD and the read data RD, $\overline{RD}$, so that the output buffer 19 commences operation and supplies the read data at the output terminal $D_{out}$. At the same time when the operation of the output buffer driver 19a is completed, signal DBR is generated so as to reset the data buffer 18. This signal DBR is automatically reset by the timing circuit included in the output buffer driver 19a about the time when the data buffer 18 is completely reset by the signal DBR. On the other hand, the output signal OBD of the output buffer driver 19a is maintained till the time when the output buffer driver receives the signal CDD in the next cycle so that the read data is maintained at the output terminal $D_{out}$.

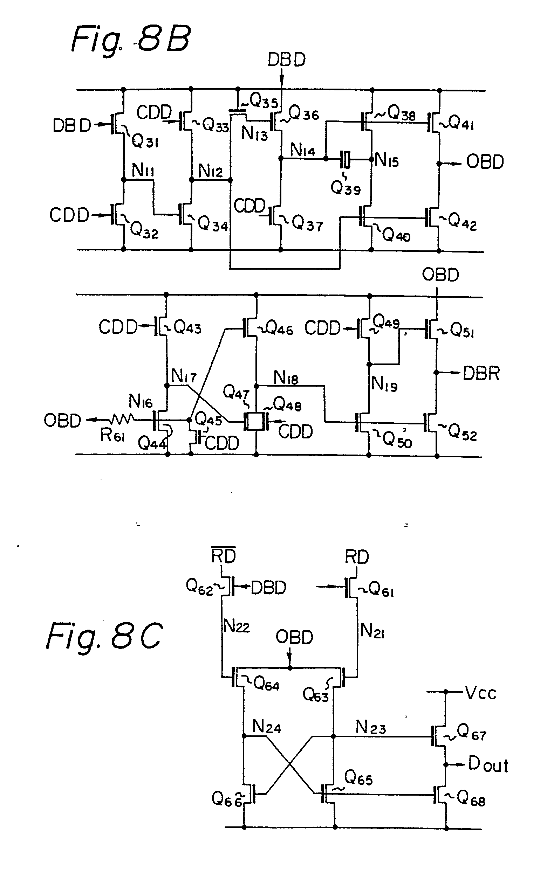

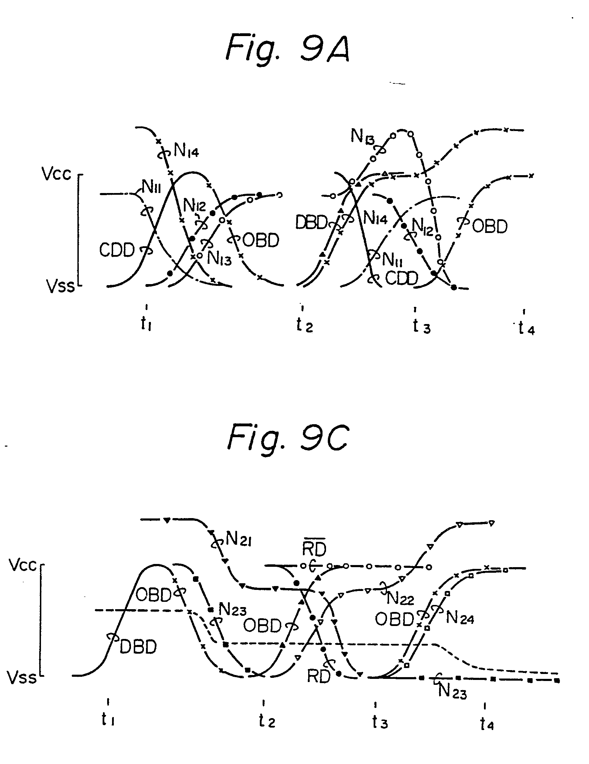

Figure 8B is a practical circuit configuration of output buffer driver 19a. $Q_{31}$ to $Q_{52}$ are MOS transistors or MOS capacitors and $N_{11}$ to $N_{19}$ are nodes or potentials at the nodes. The circuit which is formed by transistors $Q_{31}$ to $Q_{42}$ is the circuit which forms the signal OBD. The timing chart of this circuit is shown in Figure 9A. At first, when the signal CDD is placed at high level, the potential at node $N_{11}$ is placed at low level, the potential at nodes $N_{12}$ and $N_{13}$ is placed at high level and the potential at the node $N_{14}$ is placed at low level so that this circuit is reset, the transistor $Q_{41}$ is placed in the off state, the transistor $Q_{42}$ is placed in the on state and the signal OBD is placed at low level. After the reset is completed, at the time $t_2$, the signal DBD is placed at high level and the signal CDD is placed at low level so that this circuit commences operation.

When node $N_{14}$ is placed at high level and node $N_{12}$ is placed at low level, the transistor $Q_{41}$ is placed in the on state, the transistor $Q_{42}$ is_in the_ off state, the signal OBD is placed at high level so that the output buffer 19b is driven.

The circuit which includes the transistors $Q_{43}$ to

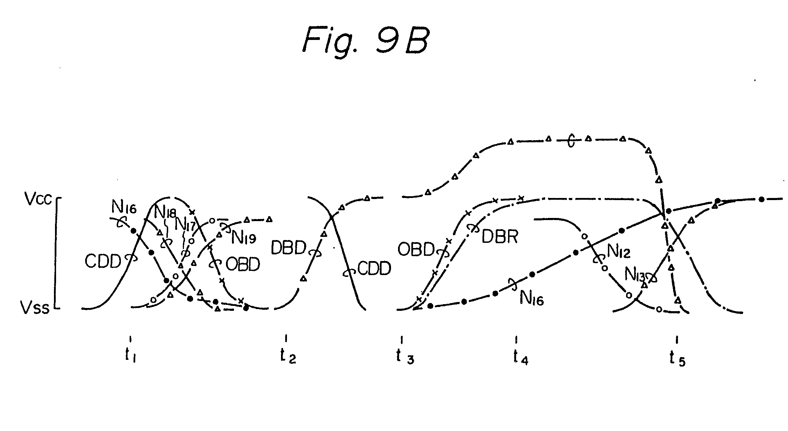

$Q_{52}$ and a resistor $R_{61}$ is the circuit for forming the signal DBR and the timing chart of this circuit is shown in Figure 9B. This circuit is reset by the signal CDD. After this circuit is reset, when the signal OBD is placed at high level, the signal DBR is also placed at high level. Thereafter, the node $N_{18}$ is placed at high level by the timing circuit including transistors $Q_{43}$ to $Q_{48}$ and the resistor $R_{61}$. Therefore, the transistor $Q_{50}$ is placed in the on state, the node $N_{19}$ is placed at low level and the transistor $Q_{51}$ is placed in the off state. On the other hand, the transistor $Q_{52}$ is placed in the on state so that the signal DBR is placed at low level via the transistor $Q_{52}$. Figure 8C is a practical circuit of the output buffer 19b. $Q_{61}$ to $Q_{68}$ are MOS transistors and $N_{21}$ to $N_{24}$ are nodes or potentials at the nodes. The time chart of the output buffer 19b is shown in Figure 9C. At the time $t_1$ the node $N_{23}$ is placed at high level and the transistor $Q_{67}$ is placed in the on state and therefore high level is output at the output terminal $D_{out}$. At the time $t_2$, the signal OBD is placed at low level, the potential of node $N_{23}$ is discharged via the transistor $Q_{63}$ to the signal OBD, the transistor $Q_{67}$ is placed in the off state and is reset. At the time $t_3$, the potential levels of the nodes $N_{21}$ and $N_{22}$ are determined by the signals RD, $\overline{RD}$. That is, one of the nodes $N_{21}$ and $N_{22}$ is placed at high level and another of them is placed at low level. In the example shown in Figure 9C, the node $N_{22}$ is at high level and the node $N_{21}$ is at low level. Thereafter, when the signal OBD is placed at high level, as the transistor $Q_{64}$ is in the on state, the node $N_{24}$ is placed at high level, so that the transistor $Q_{63}$ is placed in the on state. On the other hand, if the signal OBD is placed at high level, the transistor $Q_{63}$ is in the off state, therefore, the node $N_{23}$ is maintained at low level and the transistor $Q_{67}$ is in the off state. Therefore, the output $D_{out}$ is placed in low level state.

According to an embodiment of the present invention, as illustrated in the foregoing, an individual functional block (except the output buffer) which has finished a functional block operation, is readily reset by a signal from a functional block of the next stage or of the next but one stage. The output buffer, which maintains last-provided read data on the $D_{out}$ terminal, is reset with a signal from the column decoder just before the output buffer commences a new operation. Therefore, it is possible to greatly reduce the cycle time of the dynamic memory and, eventually, to write and read large amounts of data within reduced periods of time.

A semiconductor dynamic memory embodying this invention includes a plurality of functional blocks for control in the memory, such as a row-enable buffer, a row-address buffer, a word decoder, a column-enable buffer, a column-address buffer, and a column decoder. The functional blocks in the semiconductor dynamic memory are sequentially reset by signals which prove the operations of the functional blocks of the subsequent stages, and are returned to the state in which they are ready to execute the next processing.

It will be appreciated that the row-enable buffer can be arranged so as to commence operation upon occurrence of a rising edge of an external clock signal or upon occurrence of a falling edge of an external clock signal. The column-enable buffer can then be arranged so as to commence operation upon occurrence of the falling edge of the external clock signal or upon occurrence of the rising edge of the external clock signal.

**Claims**

1. A dynamic semiconductor memory comprising a plurality of functional blocks such as a row-enable buffer (REB, 11), a row address buffer (RAB, 12) which receives an output signal (RE) of said row-enable buffer, a word decoder (WD, 13) which is connected to said row address buffer, a group of sense amplifiers (SA, 17; SA1 to SAn, 17a to 17n), a column enable buffer (CEB, 14) a column address buffer (CAB, 15) which receives an output signal (CE) of said column enable buffer, a column decoder (CD, 16; CD1 to CDn, 16a, to 16n; 16a, 16b) which receives a column address signal (CA) from said column address buffer and which selects one of said sense amplifiers, a data buffer (DB, 18; 18a, 18b) which receives an output of the selected sense amplifier, and an output buffer (OB, 19; 19a, 19b) which is connected to said data buffer, characterised in that individual functional blocks are successively reset, each immediately after a processing operation thereof so as to be ready to execute a next processing operation.

2. A memory as claimed in claim 1, wherein said row-enable buffer (REB, 11) is reset by a signal provided from said row address buffer (RAB 12), and said row address buffer is reset by a signal provided from said word decoder (WD, 13).

3. A memory as claimed in claim 1 or 2, wherein said column-enable buffer (CEB, 14) is reset by a signal provided from said column address buffer (CAB, 15) and said column address buffer is reset by a signal provided from said column decoder (CD, 16; CD1 to CDn, 16a to 16n; 16a, 16b).

4. A memory as claimed in claim 1, 2 or 3, wherein both said word decoder (WD, 13) and said sense amplifiers (SA, 17; SA1 to SAn, 17a to 17n) are reset by a signal provided from said column decoder (CD, 16; CD1 to CDn; 16a to 16n; 16a, 16b).

5. A memory as claimed in claim 1, 2, 3 or 4, wherein said output buffer (OB, 19; 19a, 19b) is reset by a signal (DL, CDD) provided from said column decoder (CD, 16; CD1 to CDn, 16a to 16n; 16a, 16b).

6. A memory as claimed in claim 1, 2, 3, 4 or 5, wherein said column decoder (CD, 16; CD1 to CDn, 16a to 16n; 16a, 16b) is reset by a signal provided from said data buffer (DB, 18; 18a, 18b), and said data buffer is reset by a signal (DBR) provided from the output buffer (OB, 19; 19a, 19b).

7. A memory as claimed in any one of claims 2 to 6, wherein each signal provided by one functional block for resetting another functional block, after a processing operation of this other functional block, is provided only when the one functional block has begun a processing operation which employs an output of the other functional block provided by the said processing operation of the other functional block.

8. A memory as claimed in any preceding claim, wherein said row-enable buffer (REB, 11) commences to operate upon occurrence of a rising edge of an external clock signal ($\overline{RAS}$) or upon occurrence of a falling edge of an external clock signal ($\overline{RAS}$) and said column-enable buffer (CEB, 14) commences to operate upon occurrence of the falling edge of the external clock signal or upon occurrence of the rising edge of the external clock signal.

## Patentansprüche

1. Dynamischer Halbleiterspeicher mit einer Vielzahl von funktionalen Blöcken, wie einem Reihenfreigabepuffer (REB, 11), einem Reihenadressenpuffer (RAB, 12), welcher ein Ausgangssignal (RE) des genannten Reihenfreigabepuffers empfängt, einem Wortdecoder (WD, 13), der mit dem genannten Reihenadressenpuffer verbunden ist, einer Gruppe von Leseverstärkern (SA, 17; SA1 bis SAn, 17a bis 17n), einem Spaltenfreigabepuffer (CEB, 14), einem Spaltenadressenpuffer (CAB, 15), der ein Ausgangssignal (CE) des genannten Spaltenfreigabepuffers empfängt, einem Spaltendecoder (CD, 16; CD1 bis CDn, 16a bis 16n; 16a, 16b), der ein Spaltenaddressensignal (CA) von dem genannten Spaltenadressenpuffer empfängt und einen der genannten Leseverstärker auswählt, einem Datenpuffer (DB, 18; 18a, 18b), der einen Ausgang des ausgewählten Leseverstärkers empfängt, und einem Ausgangspuffer (OB, 19; 19a, 19b), der mit dem genannten Datenpuffer verbunden ist, dadurch gekennzeichnet, daß individuelle funktionale Blöcke nacheinander zurückgesetzt werden, jeder unmittelbar nach einem Verarbeitungsbetrieb desselben, um so bereit zu sein, einen nächsten Verarbeitungsbetrieb auszuführen.

2. Speicher nach Anspruch 1, bei welchem der genannte Reihenfreigabepuffer (REB, 11) durch ein Signal zurückgesetzt wird, welches von dem genannten Reihenadressenpuffer (RAB, 12) geliefert wird, und der genannte Reihenadressenpuffer durch ein Signal zurückgesetzt wird, welches von dem genannten Wortdecoder (WD, 13) geliefert wird.

3. Speicher nach Anspruch 1 oder 2, bei welchem der genannte Spaltenfreigabepuffer (CEB, 14) durch ein Signal zurückgesetzt wird, welches von dem genannten Spaltenadressenpuffer (CAB, 15) geliefert wird, und der Spaltenadressenpuffer durch ein Signal zurückgesetzt wird, welches von dem genannten Spaltendecoder (CD, 16; CD1 bis CDn, 16a bis 16n; 16a, 16b) geliefert wird.

4. Speicher nach Anspruch 1, 2 oder 3, bei welchem beide genannten Wortdecoder (WD, 13) und die genannten Leseverstärker (SA, 17; SA1 bis SAn, 17a bis 17n) durch ein Signal zurückgesetzt werden, welches von dem genannten Spaltendecoder (CD, 16; CD1 bis CDn; 16a bis 16n; 16a, 16b) geliefert wird.

5. Speicher nach Anspruch 1, 2, 3 oder 4, bei welchem der genannte Ausgangspuffer (OB, 19; 19a, 19b) durch ein Signal (DL, CDD) zurückgesetzt wird, welches von dem genannten Spaltendecoder (CD, 16; CD1 bis CDn, 16a bis 16n; 16a, 16b) geliefert wird.

6. Speicher nach Anspruch 1, 2, 3, 4 oder 5, bei welchem der genannte Spaltendecoder (CD, 16, CD1 bis CDn, 16a bis 16n; 16a, 16b) durch ein Signal zurückgesetzt wird, welches von dem genannten Datenpuffer (DB, 18; 18a, 18b) geliefert wird, und der genannte Datenpuffer durch ein Signal (DBR) zurückgesetzt wird, welches von dem Ausgangspuffer (OB, 19; 19a, 19b) geliefert wird.

7. Speicher nach einem der Ansprüche 2 bis 6, bei welchem jedes Signal, welches von einem funktionalen Block zur Zurücksetzung eines anderen funktionalen Blockes geliefert wird, nach einem Verarbeitungsbetrieb dieses anderen funktionalen Blockes, nur dann geliefert wird, wenn der eine funktionale Block einen Verarbeitungsbetrieb begonnen hat, der einen Ausgang des anderen funktionalen Blockes verwendet, der durch den genannten Verarbeitungsbetrieb des anderen funktionalen Blockes geliefert wird.

8. Speicher nach einem der vorhergehenden Ansprüche, bei welchem der genannte Reihenfreigabepuffer (REB, 11) beim Auftreten der ansteigenden Flanke eines externen Taktsignals ($\overline{RAS}$) oder beim Auftreten einer abfallenden Flanke eines externen Taktsignals ($\overline{RAS}$) zu arbeiten beginnt, und der genannte Spaltenfreigabepuffer (CEB, 14) bei Auftreten der abfallenden Flanke des externen Taktsignals oder beim Auftreten der ansteigenden Flanke des externen Taktsignals zu arbeiten beginnt.

## Revendications

1. Mémoire dynamique à semi-conducteurs, comportant plusieurs blocs fonctionnels comme un tampon d'autorisation de rangée (REB, 11), un tampon d'adresse de rangée (RAB, 12) qui reçoit un signal de sortie (RE) dudit tampon d'autorisation de rangée, un décodeur de mot (WD, 13) qui est connecté audit tampon d'adresse de rangée, un groupe d'amplificateurs de lecture (SA, 17; SA1 à SAn, 17a à 17n), un tampon d'autorisation de colonne (CEB 14), un tampon d'adresse de colonne (CAB 15) qui reçoit un signal de sortie (CE) dudit tampon d'autorisation de colonne, un décodeur de colonne (CD, 16; CD1 à CDn, 16a à 16n; 16a, 16b) qui reçoit un signal d'adresse de colonne (CA) provenant dudit tampon d'adresse de colonne et qui sélectionne l'un desdits amplificateurs de lecture, un tampon de données (DB; 18; 18a, 18b) qui reçoit une sortie de l'amplificateur de lecture sélectionné et un tampon de sortie (OB, 19; 19a, 19b) qui est connecté audit tampon de données, caractérisé en ce que des blocs fonctionnels individuels sont ramenés successivement au repos, chacun immédiatement après une opération de de traitement de manière à être prêt à exécuter une opération de traitement suivante.

2. Mémoire selon la revendication 1, dans laquelle ledit tampon d'autorisation de rangée (REB, 11) est ramené au repos par un signal produit par ledit tampon d'adresse de rangée (RAB, 12) et ledit tampon d'adresse de rangée est ramené au repos par un signal produit par ledit décodeur de mot (WD, 13).

3. Mémoire selon la revendication 1 ou 2, dans laquelle ledit tampon d'autorisation de colonne (CEB, 14) est ramené au repos par un signal produit par ledit tampon d'adresse de colonne (CAB, 15) et ledit tampon d'adresse de colonne est ramené au repos par un signal produit par ledit décodeur de colonne (CD, 16; CD1 à CDn, 16a à 16n; 16a, 16b).

4. Mémoire selon la revendication 1, 2 ou 3, dans laquelle ledit décodeur de mot (WD, 13) et lesdits amplificateurs de lecture (SA, 17; SA1 à SAn, 17a à 17n) sont ramenés au repos par un signal produit par ledit décodeur de colonne (CD, 16; CD1 à CDn, 16a à 16n; 16a, 16b).

5. Mémoire selon la revendication 1, 2, 3 ou 4, dans laquelle ledit tampon de sortie (OB, 19; 19a, 19b) est ramené au repos par un signal (DL, CDD) produit par ledit décodeur de colonne (CD, 16; CD1 à CDn, 16a à 16n; 16a, 16b).

6. Mémoire selon la revendication 1, 2, 3, 4 ou 5, dans laquelle ledit décodeur de colonne (CD, 16; CD1 à CDn, 16a à 16n; 16a, 16b) est ramené au repos par un signal produit par ledit tampon de données (DB, 18; 18a, 18b) et ledit tampon de données est ramené au repos par un signal (DBR) produit par le tampon de sortie (OB, 19; 19a, 19b).

7. Mémoire selon l'une quelconque des revendications 2 à 6, dans laquelle chaque signal produit par un bloc fonctionnel pour ramener au repos un autre bloc fonctionnel après une opération de traitement de cet autre bloc fonctionnel, n'est produit que si ledit bloc fonctionnel a commencé une opération de traitement qui utilise une sortie de l'autre bloc fonctionnel produite par ladite opération de traitement de l'autre bloc fonctionnel.

8. Mémoire selon l'une quelconque des revendications précédentes, dans laquelle ledit tampon d'autorisation de rangée (REB, 11) commence à fonctionner à l'apparition d'une transition croissante d'un signal d'horloge extérieure ($\overline{RAS}$) ou à l'apparition d'une transition décroissante d'un signal d'horloge extérieure ($\overline{RAS}$) et ledit tampon d'autorisation de colonne (CEB, 14) commence à fonctionner à l'apparition d'une transition décroissante du signal d'horloge extérieure ou à l'apparition d'une transition croissante du signal d'horloge extérieure.

## Fig. 1

Fig. 2

| | O(NS) | 50 | 100 | 150 | 200 | 250 | 270 |

(a) $\overline{RAS}$

(b) $\overline{CAS}$

(c) REB

(d) RAB

(e) WD

(f) SA

(g) CEB

(h) CAB

(i) CD        ⌐⌐ ACTIVE PERIOD

(j) DB        ⌐⌐ RESET PERIOD

(k) OB

(ℓ) DO        ⟨ R D ⟩

0 037 252

## Fig. 3

Fig. 4

# Fig. 5

# Fig. 6

# Fig. 7

# Fig. 8A

TO WD 13, SA17, WSC20

BD  $\overline{BD}$

RST

COLUMN DECODER DRIVER ~16a

RST

COLUMN DECODER (NOR GATE) 16b /16

CDD

RST

DL  $\overline{DL}$

DATA BUFFER DRIVER RST

DATA BUFFER 18b /18

18a  DBD

RST

RD  $\overline{RD}$

OUTPUT BUFFER DRIVER RST

DBR

OUTPUT BUFFER 19b /19

19a  OBD

Dout

7

Fig. 8B

Fig. 8C

# Fig. 9A

# Fig. 9C

Fig. 9B